# EUROPÄISCHE PATENTSCHRIFT

(11) **EP 1 060 444 B1**
(45) Veröffentlichungstag und Bekanntmachung des Hinweises auf die Patenterteilung: **15.05.2002**
(21) Anmeldenummer: 99911585.0
(22) Anmeldetag: 05.02.1999
(51) Int. Cl.: G06F 1/18, H05K 7/14

(54) **CHASSIS ZUR AUFNAHME VON ELEKTRONIKKARTEN**
RACK ASSEMBLY FOR RECEIVING ELECTRONIC CARDS
CHASSIS POUR LOGER DES CARTES ELECTRONIQUES

(30) Priorität: 13.02.1998 DE 19806025
(43) Veröffentlichungstag der Anmeldung: 20.12.2000
(73) Patentinhaber: Fujitsu Siemens Computers GmbH, 81739 München (DE)
(72) Erfinder: DOEINGHAUS, Hermann, D-33129 Delbrück (DE); KOEHLER, Friedrich, D-86405 Meitingen (DE); MUELLER, Bernd, D-86507 Oberottmarshausen (DE)
(74) Vertreter: Hermann, Uwe, Dipl.-Ing.
(86) Internationale Anmeldenummer: DE9900323
(87) Internationale Veröffentlichungsnummer: WO9941655

(56) Entgegenhaltungen:
- DE-C- 3 744 603
- US-A- 5 564 930
- US-A- 5 754 406
- PATENT ABSTRACTS OF JAPAN vol. 018, no. 155 (E-1524), 15. März 1994 & JP 05 334933 A (NEC CORP;OTHERS: 01), 17. Dezember 1993

## Beschreibung

Die Erfindung betrifft ein Chassis zur Aufnahme von Elektronikkarten gemäß dem Oberbegriff des Anspruchs 1.

In einem solchen Chassis, wie es beispielsweise aus der US 5 564 930 A bekannten ist, liegen die Steckplätze für die Elektronikkarten relativ nah beieinander. Dadurch besteht beim Einstecken und Herausziehen der Elektronikkarten die Gefahr, daß die auf den Elektronikkarten angeordneten elektronischen Bauelemente oder die offen liegenden Kontaktelemente und Leiterbahnen beim Herausnehmen oder Einsetzen der Elektronikkarten durch Berührung mit den Nachbarkarten beschädigt werden oder daß Kurzschlüsse erzeugt werden. Dies gilt um so mehr, als beim Herausziehen der Elektronikkarten erhebliche Steckkräfte überwunden werden müssen und die Elektronikkarten wegen der dichten Packung der auf ihnen angeordneten Bauelemente in der Regel schlecht zu fassen sind.

Aus der DE 37 44 603 C1 ist es bekannt, Leiterplatten unter Zwischenlage von Isolierplatten zu einem Leiterplattenpaket aufzuschichten. Soll eine Leiterplatte aus dem Paket herausgenommen werden, so müssen die Platten des Leiterplattenpaketes Schicht für Schicht abgetragen werden, bis man an die zu entfernende Leiterplatte herankommt. Es ist nicht möglich, eine im Leiterplattenpaket liegende Leiterplatte aus dem Paket zu entnehmen, ohne die Lage zumindest der darüber angeordneten Nachbar-Leiterplatte zu verändern.

Aus US 5 754 406 ist ferner eine Leiterplattenanordnung bekannt, bei der an den Steckplätzen mehrerer parallel angeordneter Leiterplatten, jeweils zwei U-förmige Schutzbügel vorgesehen sind, die die dazwischen liegenden Leiterplatten beidseitig abschirmen.

Der Erfindung liegt die Aufgabe zugrunde, ein Chassis der oben genannten Art so auszubilden, daß bei dem Einstecken oder Herausnehmen einer Elektronikkarte eine Beschädigung derselben oder von Nachbarkarten mit einfachen Mitteln zuverlässig vermieden werden kann.

Diese Aufgabe wird durch die im kennzeichnenden Teil des Anspruchs 1 angegebenen Merkmale gelöst.

Selbst wenn also beim Herausziehen einer Elektronikkarte diese nach dem Überwinden der Steckkräfte eine unkontrollierte ruckartige Bewegung macht, besteht keine Gefahr, daß die Elektronikkarte dabei eine Nachbarkarte streift und diese beschädigt oder selbst beschädigt wird. Dies spielt insbesondere auch eine wesentliche Rolle, wenn eine Elektronikkarte bei laufendem Gerät gezogen werden soll.

Die Steckwand kann eine Chassiswand, die lediglich die Gegenstecker trägt, oder auch eine Hauptplatine sein, die selber mit elektronischen Bauelementen bestückt ist. Im letzteren Fall ist es zweckmäßig, wenn die Hauptplatine durch eine aus einem Isoliermaterial bestehende Schutzplatte abgedeckt ist, die Durchtrittsöffnungen für die Gegenstecker oder die Steckverbinder hat, so daß auch die Hauptplatine beim Einstecken oder Herausziehen von Elektronikkarten gegen Beschädigung gesichert ist.

Die Zwischenwände können an der Steckwand oder auch an der Schutzplatte befestigt sein. Die Verbindung der Zwischenwände mit der Steckwand oder Schutzplatte kann auf einfache Weise dadurch erfolgen, daß die Zwischenwände an ihrem jeweiligen der Steckwand zugekehrten Rand mindestens einen Haken haben, der zum Eingriff in eine in der Steckwand oder der Schutzplatte ausgebildete komplementäre Öffnung bestimmt ist. Damit ist eine einfache Montage der Zwischenwände möglich. In der montierten Stellung können die Zwischenwände durch eine Rastverriegelung an der Steckwand oder Schutzplatte gesichert sein.

Wie bereits eingangs festgestellt wurde, ist der Zwischenraum zwischen den Elektronikkarten gering und wird durch die jeweilige Zwischenwand noch weiter eingeschränkt. Zudem sind die Elektronikkarten schlecht zu greifen, um die Steckkräfte zu überwinden. Um das Herausziehen der Elektronikkarten ohne eine Beschädigung derselben zu erleichtern, wird erfindungsgemäß vorgeschlagen, daß an jeder Zwischenwand ein senkrecht zur Steckwand verstellbares Zugelement verschiebbar gelagert ist, das mit mindestens einem Haken an seinem der Steckwand zugekehrten Ende den der Steckwand zugekehrten Rand einer der Zwischenwand benachbarten Elektronikkarte untergreift. Um einerseits Platz zu sparen und andererseits die erforderlichen Zugkräfte verkantungsfrei übertragen zu können, ist das Zugelement vorzugsweise plattenförmig ausgebildet und an seinem der Steckwand fernen Ende mit einer Grifföffnung versehen. Mit diesem Zugelement kann die Elektronikkarte bequem aus der Steckverbindung mit der Steckwand ausgehoben werden, sodaß sie nur noch erfaßt und aus dem Chassis herausgehoben zu werden braucht. Damit wird die Gefahr einer Beschädigung der Elektronikkarte durch unkontrollierte ruckartige Bewegungen vermieden.

Damit der Haken an dem Zugelement das Einstecken der Elektronikkarte nicht behindert, kann die Schutzplatte oder die Steckwand in Flucht mit dem Haken an dem Zugelement jeweils eine Öffnung haben, in die der Haken bei eingesteckter Elektronikkarte eintauchen kann.

Um auch die äußeren Elektronikkarten vor einer Berührung mit den Chassiswänden zu schützen, kann die Schutzplatte an ihren zu den Elektronikkarten parallelen Rändern mit die Chassiswände abdeckenden, zu den Zwischenwänden parallelen Schutzwänden verbunden sein.

Zweckmäßigerweise bestehen die Schutzplatte, die Schutzwände und die Zwischenwände aus einem transparenten Kunststoff, sodaß die Baugruppen auch durch die Zwischenwände und die Schutzabdeckungen hindurch erkennbar sind.

Die folgende Beschreibung erläutert in Verbindung mit den beigefügten Zeichnungen die Erfindung anhand eines Ausführungsbeispieles. Es zeigen:
- Figur 1: eine schematische perspektivische Teildarstellung eines Gerätechassis zur Aufnahme einer Hauptplatine und einer Mehrzahl von auf diese aufsteckbaren Elektronikkarten,
- Figur 2: eine Draufsicht auf eine Schutzplatte und mit ihr verbundene Schutzwände zum Abdecken der Hauptplatine und der seitlichen Chassiswände,
- Figur 3: eine Endansicht der in Figur 2 dargestellten Schutzanordnung und
- Figur 4: eine perspektivische Darstellung einer Zwischenwand.

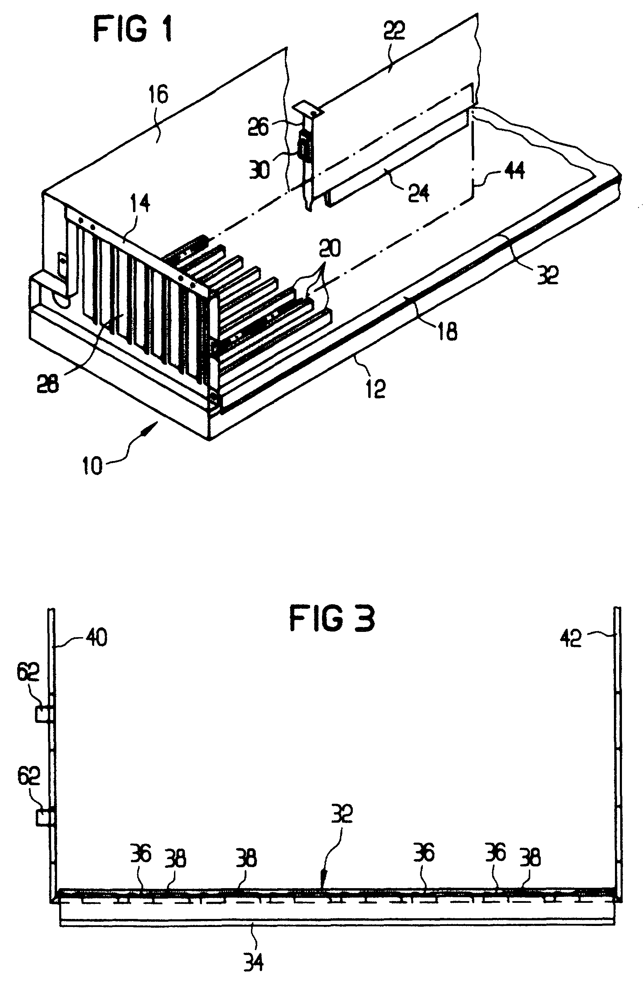

In Figur 1 sind nur die Teile des Chassis dargestellt, die für die Erläuterung der Erfindung wesentlich sind. Das Chassis umfaßt einen quaderförmigen Rahmen 10 mit einem Boden 12, einer Rückwand 14 und einer Seitenwand 16, während die gegenüberliegende Seitenwand weggelassen wurde, um den Blick in das Chassis freizugeben.

Parallel zum Boden 12 ist in dem Chassis eine Hauptplatine 18 angeordnet, die eine Mehrzahl von parallel zueinander ausgerichteten Gegensteckern 20 trägt, die jeweils eine Elektronikkarte 22 mit einem entlang einem ihrer Ränder angeordneten Stecker 24 einsteckbar ist, so daß die Elektronikkarte 22 senkrecht zur Ebene der Hauptplatine gerichtet ist. Die Elektronikkarte 22 ist an ihrem der Rückwand 14 des Chassis 10 zugekehrten Rand mit einer Blende 26 verbunden, die zum Abdecken einer schlitzförmigen Öffnung 28 in der Chassisrückwand 14 dient und einen Stecker 30 hat, über den eine periphere Einrichtung an die Elektronikkarte 22 anschließbar ist. Der soweit beschriebene Aufbau ist üblich und wohl bekannt und braucht daher nicht noch weiter erläutert zu werden.

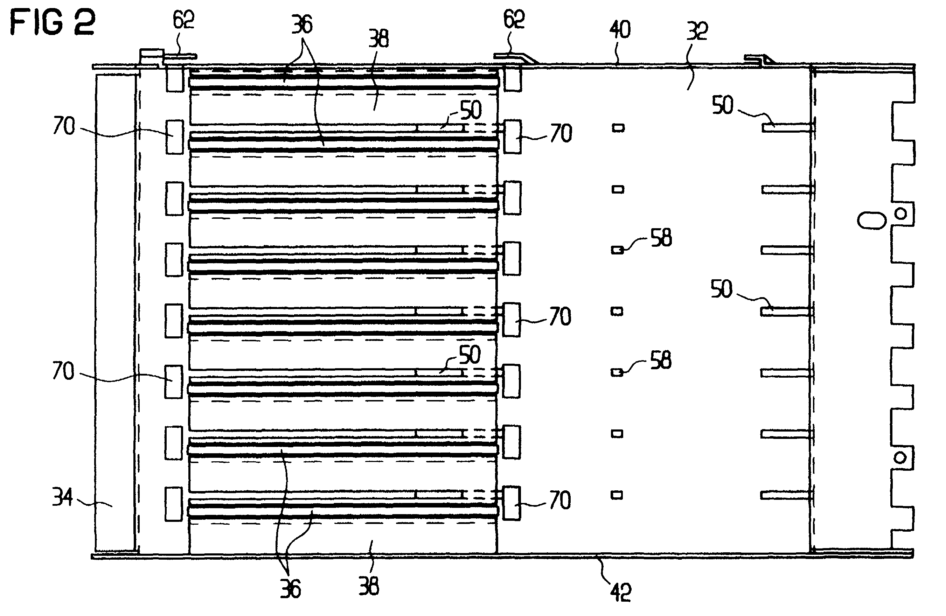

Zum Schutz der Hauptplatine gegen unbeabsichtigte Berührung dient eine in Figur 2 dargestellte Schutzplatte 32, welche die Hauptplatine 18 abdecken soll. Die Schutzplatte 32 besteht aus Isoliermaterial, beispielsweise einem transparenten Kunststoff. Sie hat an ihrem in Figur 2 linken Ende einen stufenförmig abgeknickten Flansch 34, mit dem sie auf der Hauptplatine 18 aufliegt. Durch diese Stufe erhält der Rest der Schutzplatte 32 einen Abstand von der Hauptplatine. An ihrem in Figur 2 rechten Ende kann die Schutzplatte 32 mit dem Chassis verbunden, beispielsweise an diesem angeschraubt werden.

In dem den Gegensteckern 20 auf der Hauptplatine 18 entsprechenden Bereich hat die Schutzplatte 32 langgestreckte Öffnungen 36, durch die hindurch die Stecker 24 an den Elektronikkarten 22 in die Gegenstecker 20 gesteckt werden können. Diese Öffnungen 36 liegen jeweils zwischen zwei Erhebungen 38, die in der Schutzplatte 32 ausgebildet sind, so daß zwischen diesen Erhebungen eine Führung für die jeweilige Elektronikkarte 22 gebildet wird.

An ihrem zu den Öffnungen 36 parallelen Längsränder ist die Schutzplatte 32 jeweils mit einer seitlichen Schutzwand 40 bzw. 42 verbunden. Diese Schutzwände 40 und 42 dienen dazu, die Chassisseitenwände abzudecken und eine Berührung von einzusteckenden Elektronikkarten mit den Chassisseitenwänden zu verhindern.

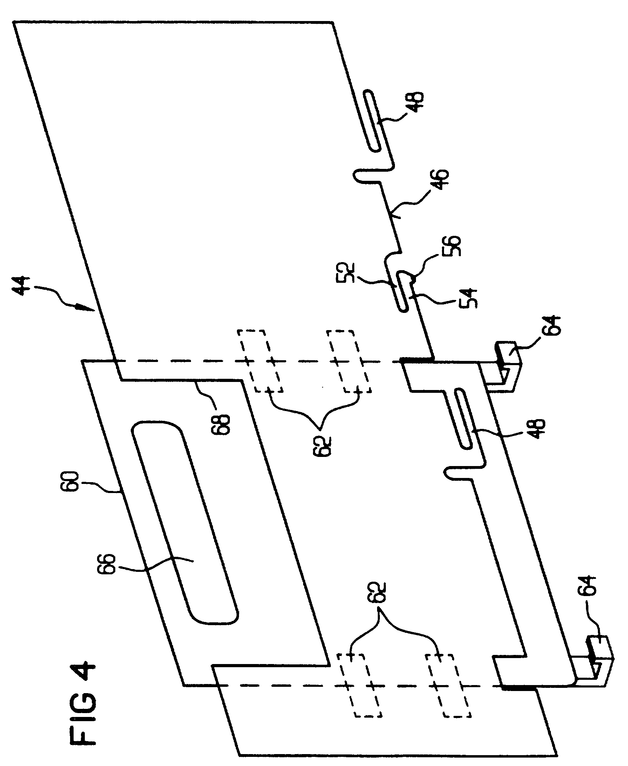

Um eine Berührung der Elektronikkarten 22 untereinander zu verhindern, ist zwischen je zwei Steckplätzen eine in Figur 1 nur angedeutete Zwischenwand 44 angeordnet, die in Figur 4 genauer dargestellt ist. Sie besteht im wesentlichen aus einer rechteckigen Kunststoffplatte, die an ihrem der Schutzplatte 32 zugekehrten unteren Rand 46 zwei Haken 48 hat, die zum Eingriff in schlitzförmige Öffnungen 50 in der Schutzplatte 32 bestimmt sind. Ferner ist an dem unteren Rand 46 der Zwischenwand 44 durch einen Einschnitt 52 eine Federzunge 54 gebildet, die mit einer nach unten weisenden Rastnase 56 versehen ist. Die Zwischenwand 44 wird mit den Haken 48 in die Durchbrechungen 50 der Schutzplatte 32 eingesetzt und dann parallel zu sich selbst verschoben, bis die Haken 48 unter das Material der Schutzplatte 32 greifen. Dabei rastet die Rastnase 56 in einer Öffnung 58 in der Schutzplatte 32 ein und hält die Zwischenwand 44 somit in ihrer eingehängten Stellung fest.

In dem Bereich der Zwischenwand 44, der nach der Montage derselben an der Schutzplatte 32 zwischen den Öffnungen 36 in der Schutzplatte 32 zu liegen kommt, ist an der Zwischenwand 44 eine Ausziehhilfe in Form einer Zugplatte 60 verschiebbar gelagert. Die Zugplatte ist mit Hilfe von Laschen 62 an der Zwischenwand 44 parallel zu dieser verschiebbar geführt und trägt an ihrem unteren Rand zwei Ausziehhaken 64, die beiderseits des jeweiligen Steckers 24 unter den der Schutzplatte 32 zugekehrten Rand der Elektronikkarte 22 greifen. Die Auszugplatte 60 hat nahe ihrem oberen Rand eine Grifföffnung 66, wobei eine in diesem Bereich vorgesehene rechteckige Aussparung 68 in der Zwischenwand 44 das Ergreifen der Ausziehplatte 60 erleichtert.

Damit die Ausziehhaken 64 das Einstecken der Elektronikkarte 22 nicht behindern, sind nahe den Längsenden der Stekkeröffnungen 36 in der Schutzplatte 32 jeweils rechteckige Öffnungen 70 ausgebildet, in die die Auszughaken 64 eintauchen können. Soll eine gesteckte Elektronikkarte 22 aus ihrem Steckplatz herausgenommen werden, erfaßt man die Zugplatte 60 und zieht diese an der Zwischenwand 44 nach oben. Dabei treten die Ausziehhaken 64 durch die Öffnungen 70, untergreifen die Elektronikkarte 22 beiderseits des Stekkers 24 und ziehen die Karte 22 mit dem Stecker 24 verkantungsfrei nach oben. Es genügt, den Stecker 24 aus dem Gegenstecker 20 herauszuheben. Anschließend kann die Elektronikkarte 22 ohne Mühe zwischen den benachbarten Zwischenwänden herausgehoben werden, ohne daß die Gefahr einer Berührung oder gar Beschädigung der Elektronikkarte oder ihrer Nachbarkarten besteht.

Figur 2 zeigt ferner, daß auch an der mit der Schutzplatte 32 verbundenen seitlichen Schutzwand 40 eine Ausziehhilfe 60 in der gleichen Weise wie an den Zwischenwänden 44 gelagert ist.

## Patentansprüche

1. Chassis zur Aufnahme von Elektronikkarten (22), die parallel zueinander und in einem Abstand voneinander über jeweils mindestens einen Steckverbinder (24) auf eine Gegenstecker (20) tragende und senkrecht zu den Elektronikkarten (22) gerichtete Steckwand (18) aufsteckbar sind, **dadurch gekennzeichnet, daß** zwischen je zwei Elektronikkarten (22) eine aus einem Isoliermaterial bestehende Zwischenwand (44) angeordnet ist, die an der Steckwand (18) oder an einer aus Isoliermaterial bestehenden, die Steckwand abdeckenden, Durchtrittsöffnungen für die Steckverbinder (24) aufweisenden Schutzplatte (32) befestigt ist.

2. Chassis nach Anspruch 1, **dadurch gekennzeichnet, daß** die Zwischenwände (44) an ihrem jeweiligen der Steckwand (18) zugekehrten Rand (46) mindestens einen Haken (48) haben, der zum Eingriff in eine in der Steckwand (18) oder der Schutzplatte (32) ausgebildete komplementäre Öffnung (50) bestimmt ist.

3. Chassis nach Anspruch 1 oder 2, **dadurch gekennzeichnet, daß** die Zwischenwände (44) durch eine Rastverriegelung (56, 58) an der Steckwand (18) oder der Schutzplatte (32) gesichert sind.

4. Chassis nach einem der vorhergehenden Ansprüche, **dadurch gekennzeichnet, daß** an jeder Zwischenwand (44) ein senkrecht zur Steckwand (18) verstellbares Zugelement (60) verschiebbar gelagert ist, das mit mindestens einem Haken (64) an seinem der Steckwand (18) zugekehrten Ende den der Steckwand (18) zugekehrten Rand einer der zwischenwand benachbarten Elektronikkarte (22) untergreift.

5. Chassis nach Anspruch 4, **dadurch gekennzeichnet, daß** das Zugelement (60) plattenförmig ausgebildet ist und nahe seinem der Steckwand fernen Ende eine Grifföffnung (66) hat.

6. Chassis nach Anspruch 4 oder 5, **dadurch gekennzeichnet, daß** die Schutzplatte (32) oder die Steckwand (18) in Flucht mit dem Haken (64) an dem Zugelement (60) jeweils eine Öffnung (70) hat, in die der Haken (64) bei eingesteckter Elektronikkarte (62) eintauchen kann.

7. Chassis nach einem der vorhergehenden Ansprüche, **dadurch gekennzeichnet, daß** die Schutzplatte (32) an ihren zu den Elektronikkarten (22) parallelen Rändern mit die Chassiswände abdeckenden Schutzwänden (40, 42) verbunden ist.

8. Chassis nach Anspruch 7, **dadurch gekennzeichnet, daß** die Schutzplatte (32), die Schutzwände (40, 42) und die Zwischenwände (44) aus einem transparenten Kunststoff hergestellt sind.

## Claims

1. Chassis for accommodating electronic cards (22) which can be plugged parallel to one another, and at a distance from one another, via in each case at least one plug connector (24), onto a plug-connection wall (18) which bears mating plugs (20) and is directed perpendicularly to the electronic cards (22), **characterized in that** arranged between in each case two electronic cards (22) is an intermediate wall (44) which consists of an insulating material and is fastened on the plug-connection wall (18) or on a protective panel (32) which consists of insulating material, covers the plug-connection wall and has through-passage openings for the plug connectors (24).

2. Chassis according to Claim 1, **characterized in that** on their respective border (46), which is directed towards the plug-connection wall (18), the intermediate walls (44) have at least one hook (48) which is intended for engaging in a complementary opening (50) formed in the plug-connection wall (18) or the protective panel (32).

3. Chassis according to Claim 1 or 2, **characterized in that** the intermediate walls (44) are secured on the plug-connection wall (18) or the protective panel (32) by a latching-type locking means (56, 58).

4. Chassis according to one of the preceding claims, **characterized in that** mounted displaceably on each intermediate wall (44) is a pulling element (60) which can be adjusted perpendicularly to the plug-connection wall (18) and, by way of at least one hook (64) at its end which is directed towards the plug-connection wall (18), engages beneath that border of an electronic card (22) adjacent to the intermediate wall which is directed towards the plug-connection wall (18).

5. Chassis according to Claim 4, **characterized in that** the pulling element (60) is of plate-like design and has a grip opening (66) in the vicinity of its end which is remote from the plug-connection wall.

6. Chassis according to Claim 4 or 5, **characterized in that**, in alignment with the hook (64) on the pulling element (60), the protective panel (32) or the plug-connection wall (18) each has an opening (70) into which the hook (64) can penetrate when the electronic card (62) has been plugged in.

7. Chassis according to one of the preceding claims, **characterized in that**, on its borders parallel to the electronic cards (22), the protective panel (32) is connected to protective walls (40, 42) which cover the chassis walls.

8. Chassis according to Claim 7, **characterized in that** the protective panel (32), the protective walls (40, 42) and the intermediate walls (44) are produced from a transparent plastic.

## Revendications

1. Châssis destiné à recevoir des cartes électroniques (22) qui sont enfichables parallèlement les unes aux autres et à distance les unes des autres à l'aide respectivement d'au moins un connecteur d'enfichage (24) sur une paroi d'enfichage (18) orientée perpendiculairement aux cartes électroniques (22) et supportant un connecteur homologue (20), **caractérisé en ce qu'**il est interposé, entre respectivement deux cartes électroniques (22), une paroi intermédiaire (44) en matériau isolant, qui est fixée à la paroi d'enfichage (18) ou bien à une plaque de protection (32) en matière isolante dans laquelle sont ménagées des ouvertures de passage destinées aux connecteurs d'enfichage (24) et qui recouvre la paroi d'enfichage.

2. Châssis selon la revendication 1, **caractérisé en ce que** les parois intermédiaires (44) comportent sur leur bord respectif (46) dirigé vers la paroi d'enfichage (18) au moins un crochet (48) qui est destiné à s'engager dans une ouverture complémentaire (50) ménagée dans la paroi d'enfichage (18) ou dans la plaque de protection (32).

3. Châssis selon la revendication 1 ou 2, **caractérisé en ce que** les parois intermédiaires (44) sont bloquées sur la paroi d'enfichage (18) ou sur la plaque de protection (32) par un dispositif de verrouillage (56, 58).

4. Châssis selon l'une des revendications précédentes, **caractérisé en ce qu'**il est monté, de façon mobile sur chaque paroi intermédiaire (44), un élément de traction (60) réglable perpendiculairement à la paroi d'enfichage (18), qui s'accroche au bord, dirigé vers le paroi d'enfichage (18), d'une carte électronique (22) adjacente à la paroi intermédiaire au moyen d'au moins un crochet (64) prévu à son extrémité dirigé vers la paroi d'enfichage (18).

5. Châssis selon la revendication 4, **caractérisé en ce que** l'élément de traction (60) se présente sous la forme d'une plaque et comporte près de son bord opposé à la paroi d'enfichage une ouverture de préhension (66).

6. Châssis selon la revendication 4 ou 5, **caractérisé en ce que** la plaque de protection (32) ou la paroi d'enfichage (18) comporte une ouverture (70), alignée avec le crochet (64) sur l'élément de traction (60), dans laquelle le crochet (64) peut pénétrer lorsque la carte électronique (62) est enfichée.

7. Châssis selon l'une des revendication précédentes, **caractérisé en ce que** la plaque de protection (32) est reliée sur ses bords parallèles aux cartes électroniques (22) aux parois de protection (40, 42) recouvrant les parois du châssis.

8. Châssis selon la revendication 7, **caractérisé en ce que** la plaque de protection (32), les parois de protection (40, 42) et les parois intermédiaires (44) sont fabriquées à partir d'une matière plastique transparente.
